Europäisches Patentamt

European Patent Office

Office européen des brevets

(11) Publication number: **0 295 581**
**A1**

## EUROPEAN PATENT APPLICATION

(21) Application number: 88109250.6

(22) Date of filing: 10.06.88

(51) Int. Cl.⁴: **C23F 4/00** , **H01L 21/31**

(30) Priority: 19.06.87 US 63872

(43) Date of publication of application:
**21.12.88 Bulletin 88/51**

(84) Designated Contracting States:
**DE FR GB**

(71) Applicant: **TEGAL CORPORATION**
**11 Digital Drive**
**Novato California 94947(US)**

(72) Inventor: **Krough, Ole D.**
**110 Point Lobos**
**San Francisco California 94121(US)**

(74) Representative: **Ibbotson, Harold**
**Motorola Ltd Patent and Licensing**
**Operations - Europe Jays Close Viables**
**Industrial Estate**
**Basingstoke Hampshire RG22 4PD(GB)**

(54) Process for etching aluminum in a plasma.

(57) The addition of bromine, or bromides, to the gas mixture in a plasma has been found to significantly improve selectivity when etching aluminum. Processes are disclosed based upon bromine etch gases and chlorine based etchants wherein bromine is a small but significant additive.

EP 0 295 581 A1

## PROCESS FOR ETCHING ALUMINUM IN A PLASMA

### Background of the Invention

This invention relates to etching aluminum and, in particular, to etching aluminum in a plasma reactor.

In the prior art, a variety of gases have been proposed or even used for etching aluminum. Since the product, aluminum chloride, is a gas at the working pressure of the reactor, these reactant gases typically include chlorine, either as a gas or as part of the molecule of a gaseous compound, e.g. $Cl_2$, HCl, $SiCl_4$, $CCl_4$, $BCl_3$, and $CHCl_3$.

The exact mechanism for the aluminum etch is not fully understood, although the understanding of it is improving. At present, it is believed that free chlorine, atoms or molecules, actually do the etching. An etch mixture usually comprises at least two gases, at least one of which is a particularly good source of chlorine ions. The other gas(es) either promote the formation of ions or enhance the etch by scavenging impurities. In some cases, at low operating pressures, e.g. on the order of ten millitorr, the additive gases are used to lightly sputter etch the target. The scavenging is primarily of oxygen, often present as moisture, a gaseous molecule, or oxide. An often used scavenger is $BCl_3$, although it was often considered primarily as an etchant in the past.

Due to the unpredictable nature of plasma processing, it is often difficult to categorize processes. That is, etching a given operand does not imply a certain gas or gas mixture. Similarly, a given gas mixture does not necessarily imply or exclude any particular operand. In addition, one often sees seemingly inconsistent results using certain gases on the same operand. For example, U.S. Patent 4,314,874 describes bromine trichloride as an etchant for aluminum (col. 3, lines 17-25) while U.S. Patent 4,351,696 describes bromine compounds as passivating aluminum (col. 3, lines 1-20).

Whether any given component of a gas is an etchant or not, the etch rate of the operand is not the only consideration. The mask used to pattern the operand should not etch at the same rate, i.e. a selective etch is desired. In practice, a ratio of 3:1 or greater is desired to reduce the amount of volatile mask products in the plasma reactor. As an absolute, the etch rate of the operand is important since it determines the production rate of the reactor. Thus, one tries never to reduce the etch rate of the operand, only the relative etch rate of the mask.

In view of the foregoing, it is therefore an object of the present invention to provide an improved plasma etch of aluminum.

A further object of the present invention is to provide improved selectivity in the etching of aluminum using a modification of existing processes.

An object in accordance with another aspect of the present invention is to provide a process based on bromine for etching aluminum.

### Summary of the Invention

The foregoing objects are achieved in the present invention wherein the element bromine in the form of HBr (hydrogen bromide), $BBr_3$ (boron tribromide), or $Br_2$ (bromine), is added to the gas mixture. For chlorine based chemistries, this has been found to substantially increase (e.g. double) the selectivity of aluminum to photoresist. While a bromine additive to what is essentially a chlorine chemistry enables one to retain familiar gas handling procedures, it has further been found that an all bromine chemistry retains the etch rate of chlorine chemistry while greatly reducing the etch rate of the photoresist. That is, an all bromine chemistry has been found which provides remarkably and unexpectedly improved selectivity.

### Brief Description of the Drawings

A more complete understanding of the present invention can be obtained by considering the following detailed description in conjunction with the accompanying drawings, in which:

FIG 1 illustrates a triode plasma reactor.

FIG. 2 summarizes gas flows for a number of experiments.

FIG. 3 lists results for a group of experiments selected from FIG. 2.

FIG. 4 lists results for a group of experiments selected from FIG. 2.

FIG. 5 lists results for a group of experiments selected from FIG. 2.

FIG. 6 lists results for a group of experiments selected from FIG. 2.

FIG. 7 illustrates an alternative embodiment of the present invention.

FIG. 8 illustrates an alternative embodiment of the present invention.

## Detailed Description of the Invention

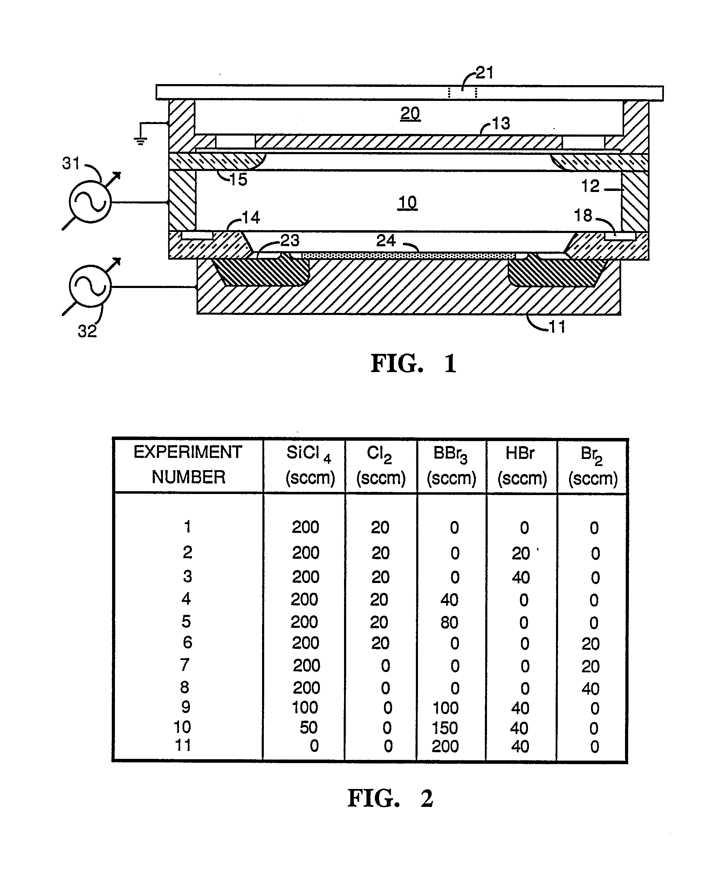

FIG. 1 illustrates a triode plasma reactor suitable for use in carrying out the present invention. As known in the art, this type of reactor comprises a central chamber 10 in which the plasma is generated, formed by lower electrode 11, sidewall 12 and upper electrode 13. The electrodes and sidewalls are electrically separated from each other by insulators 14 and 15. Upper electrode 13 forms a portion of the wall of chamber 20 which collects gases from reaction volume 10 and supplies them to an exhaust port 21. The gas or gas mixture is supplied to volume 10 by way a peripheral supply port 18. In a preferred embodiment of the present invention, upper electrode 13 is grounded, sidewall 12 is connected to RF power supply 31, and lower electrode 11 is connected to RF power supply 32. Power supply 31 preferably produces a signal having a frequency of 13.56 MHz. Source 32 preferably produces a signal having a frequency of 100 KHz.

As thus configured, one has three electrodes, hence the name triode, for causing a plasma discharge within volume 10. It is understood by those of skill in the art that a "diode" reactor could be used instead. In this embodiment, the RF power supplies are preferably connected together to lower electrode 11.

In accordance with the present invention, it has been found that one can greatly improve the chlorine based chemistries of the prior art by adding a small amount of bromine. FIG. 2 illustrates a matrix of experiments which was carried out in support of this discovery. A mixture of silicon tetrachloride and chlorine was taken as the base mixture for etching aluminum. To this mixture, boron tribromide, hydrogen bromide, and bromine gas were added, alone or in combination.

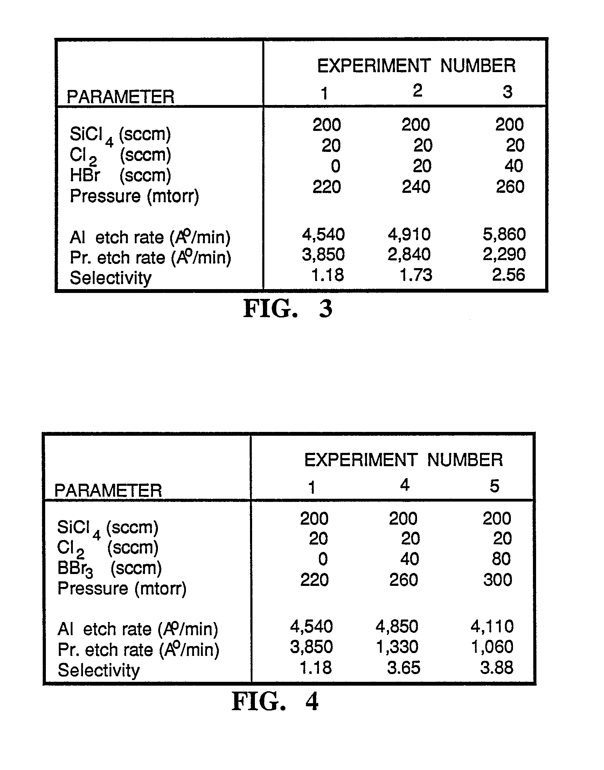

FIG. 3 illustrates a subset of the matrix of FIG. 2 wherein the effect of adding hydrogen bromide is noted with respect to a base mixture referred to herein as experiment number 1. In the examples of FIG. 3 it is apparent that the addition of hydrogen bromide significantly increases the selectivity of the etch of aluminum to photoresist. As can be seen from experiment number 3 the selectivity has more than doubled. In addition, the etch rate of the aluminum has increased somewhat.

FIG. 4 illustrates a group of experiments in which boron tribromide was added to the chlorine chemistry, resulting in significantly improved selectivity of aluminum etch to photoresist etch. The etch rate of the aluminum increased and then decreased with increasing $BBr_3$.

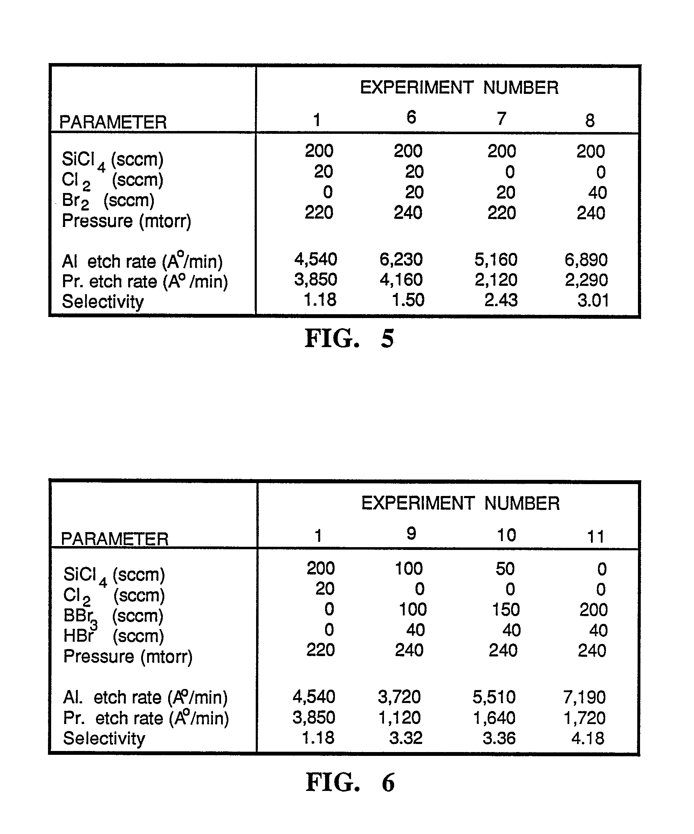

FIG. 5 illustrates additional experiments in which bromine gas was added to the chlorine mixture. In addition, the bromine gas was substituted for chlorine. As can be seen from FIG. 5 the selectivity is again significantly improved over the pure chlorine chemistry. In this series of experiments, the etch rate of the aluminum also increased.

FIG. 6 illustrates a series of experiments in which the silicon tetrachloride is gradually replaced by the boron tribromide. As before, this addition of the bromine significantly increased the selectivity of the etch.

In accordance with another aspect of the present invention, as indicated by experiment number 11 in FIG. 6, the use of a bromine based chemistry, i.e. no chlorine, provided the greatest selectivity as well as the highest etch rate.

In all of the foregoing experiments, the reactor was supplied with a 13.56 MHz signal at 600 watts, a 100 KHz signal at 50 watts. Lower electrode 11 was maintained at a temperature of $40°$ C and the experiments were performed on 100 mm. wafers having a layer of aluminum deposited thereon containing one percent silicon, and patterned so that fifty percent of the aluminum was etched. As understood by those of skill in the art, varying pressure, power and flow rates involves yet a greater matrix of experiments. It is believed that the chemistries are more significant than the pressure, power or flow rates for the present invention; i.e. the latter three parameters are readily optimized empirically for a given apparatus. In general, the high frequency power can be from 300 to 800 watts, depending upon wafer size, loading, and the like. The low frequency power can be between 30 and 80 watts. The total pressure can be from 100-500 mtorr.

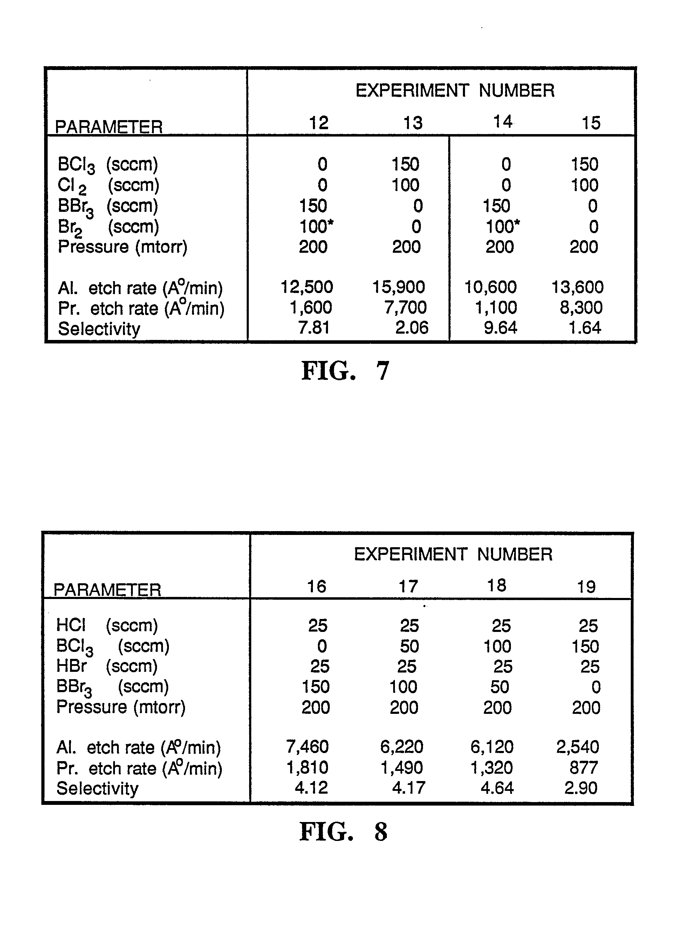

In addition to the foregoing, a series of experiments were conducted comparing what were previously considered analogous gas mixtures of chlorine or bromine. FIG. 7 illustrates a comparison of a chlorine mixture with a mixture comprising gases in which bromine has been substituted for the chlorine. In experiments 12 and 13, the supplied power at 13.56 MHz was 600 watts while the 100 KHz signal had an applied power of 30 watts. In experiments 14 and 15, the 13.56 MHz power was reduced to 400 watts. As can be seen, the bromine mixture is clearly superior to the chlorine mixture in terms of selectivity. In fact, while a slightly higher etch rate might be expected from using bromine, the improvement in selectivity was unexpected.

The flows for bromine are marked with an asterisk in FIG. 7 because that data is suspect. The etch rate usually increased with bromine, but here it did not. The flow of bromine may have been much less than indicated. There was reason to believe that the actual flow was less than 100 SCCM, and possibly oscillating, due to the accumulation of liquid in the line connecting the gas canister and the chamber. (Bromine is a liquid at room temperature). Despite this, the improvement in selectivity remains significant.

FIG. 8 illustrates a series of experiments utilizing a mixture of chlorine and bromine gases in which the flow of boron trichloride is increased while the flow of boron tribromide is decreased. Although the selectivity actually shows some improvement as one proceeds from experiment 16 to experiment 17 and 18 the absence of boron tribromide significantly alters the selectivity, as shown by experiment 19.

There is thus provided by the present invention of a significantly improved gas mixture for etching aluminum. In particular, the selectivity of the etch is enhanced to as much as five times the prior art selectivity. Gas handling is simplified since one can use familiar, chlorine based chemistries and add HBr. A somewhat less familiar chemistry would include $BBr_3$ (although this material is known and used for boron doping) and $Br_2$ as well. It is understood that the present invention relates to other bromine sources as well, such as $SiBr_4$, $CBr_4$, and $PBr_3$.

Having thus described the present invention, it will be apparent to those of skill in the art that various modifications can be made within the scope of the present invention. For example, the several examples given should not be construed as limiting as they illustrate the significant enhancement obtainable from bromine mixtures. The particular apparatus used and the applied powers and pressures are by way of example only. While described in a preferred embodiment using a single wafer, parallel plate reactor, it is understood that the present invention can be used in batch reactors as well.

## Claims

1. A process for etching aluminum in a plasma flow discharge comprising the steps of:

providing a first gas, the primary function of which is to etch aluminum;

providing a second gas, the primary function of which is to enhance the action of the first gas;

providing a bromine bearing gas, wherein the flow of bromine is less than one third of the total gas flow; and

exposing an aluminum bearing article to a plasma glow discharge formed in a mixture of said gases.

2. The process as set forth in claim 1 wherein said first gas comprises $CCl_4$, $Cl_2$, $CHCl_3$, $HCl$, $BCl_3$, $SiCl_4$ or mixtures thereof

3. The process as set forth in claim 2 wherein said bromine bearing gas is selected from the group consisting of $BR_2$, $HBr$, $BBr_3$, $SiBr_4$ $CBr_4$, and $PBr_3$.

4. The process as set forth in claim 2 wherein said bromine bearing gas is selected from the group consisting of $Br_2$, $HBr$, and $BBr_3$.

5. The process as set forth in claim 2 wherein said bromine bearing gas comprises $HBr$.

6. A process for selectively etching aluminum from the surface of a substrate on which the aluminum layer is coated with a patterned mask comprising the steps of:

providing a gas mixture from the group consisting of $Br_2$, $HBr$, $BBr_3$, $SiBr_4$, $CBr_4$, and $PBr_3$;

causing a glow discharge in said mixture; and

exposing said substrate to said glow discharge.

7. The process as set forth in claim 6 wherein said mixture consists essentially of $HBr$ and $BBr_3$.

8. The process as set forth in claim 6 wherein said mixture consists essentially of $Br_2$ and $BBr_3$.

9. In a process for selectively etching an aluminum layer on a substrate, wherein the aluminum layer is covered with a patterned layer of photoresist, wherein the process comprises exposing the substrate to a plasma glow discharge formed in an etch gas comprising $CCl_4$, $HCl$, $Cl_2$, $BCl_3$, $SiCl_4$, $CHCl_3$, $SiHCl_3$ and mixtures thereof, the improvement comprising:

adding to said gas mixture an amount of bromine bearing gas such that the total mixture is less than one third said bromine bearing gas.

10. The process as set forth in claim 9 wherein said bromine bearing gas is selected from the group consisting essentially of $HBr$, $BBr_3$, $Br_2$, and mixtures thereof.

**FIG. 1**

| EXPERIMENT NUMBER | $SiCl_4$ (sccm) | $Cl_2$ (sccm) | $BBr_3$ (sccm) | HBr (sccm) | $Br_2$ (sccm) |
|---|---|---|---|---|---|
| 1 | 200 | 20 | 0 | 0 | 0 |
| 2 | 200 | 20 | 0 | 20 | 0 |
| 3 | 200 | 20 | 0 | 40 | 0 |
| 4 | 200 | 20 | 40 | 0 | 0 |
| 5 | 200 | 20 | 80 | 0 | 0 |
| 6 | 200 | 20 | 0 | 0 | 20 |
| 7 | 200 | 0 | 0 | 0 | 20 |
| 8 | 200 | 0 | 0 | 0 | 40 |
| 9 | 100 | 0 | 100 | 40 | 0 |
| 10 | 50 | 0 | 150 | 40 | 0 |
| 11 | 0 | 0 | 200 | 40 | 0 |

**FIG. 2**

EP 0 295 581 A1

| PARAMETER | EXPERIMENT NUMBER | | |
|---|---|---|---|
| | 1 | 2 | 3 |
| $SiCl_4$ (sccm) | 200 | 200 | 200 |
| $Cl_2$ (sccm) | 20 | 20 | 20 |
| HBr (sccm) | 0 | 20 | 40 |
| Pressure (mtorr) | 220 | 240 | 260 |
| Al etch rate ($A^0$/min) | 4,540 | 4,910 | 5,860 |
| Pr. etch rate ($A^0$/min) | 3,850 | 2,840 | 2,290 |
| Selectivity | 1.18 | 1.73 | 2.56 |

## FIG. 3

| PARAMETER | EXPERIMENT NUMBER | | |
|---|---|---|---|
| | 1 | 4 | 5 |
| $SiCl_4$ (sccm) | 200 | 200 | 200 |
| $Cl_2$ (sccm) | 20 | 20 | 20 |
| $BBr_3$ (sccm) | 0 | 40 | 80 |
| Pressure (mtorr) | 220 | 260 | 300 |
| Al etch rate ($A^0$/min) | 4,540 | 4,850 | 4,110 |
| Pr. etch rate ($A^0$/min) | 3,850 | 1,330 | 1,060 |
| Selectivity | 1.18 | 3.65 | 3.88 |

## FIG. 4

EP 0 295 581 A1

| PARAMETER | EXPERIMENT NUMBER | | | |
|---|---|---|---|---|
| | 1 | 6 | 7 | 8 |
| $SiCl_4$ (sccm) | 200 | 200 | 200 | 200 |
| $Cl_2$ (sccm) | 20 | 20 | 0 | 0 |
| $Br_2$ (sccm) | 0 | 20 | 20 | 40 |
| Pressure (mtorr) | 220 | 240 | 220 | 240 |
| Al etch rate (A°/min) | 4,540 | 6,230 | 5,160 | 6,890 |
| Pr. etch rate (A° /min) | 3,850 | 4,160 | 2,120 | 2,290 |
| Selectivity | 1.18 | 1.50 | 2.43 | 3.01 |

**FIG. 5**

| PARAMETER | EXPERIMENT NUMBER | | | |
|---|---|---|---|---|
| | 1 | 9 | 10 | 11 |
| $SiCl_4$ (sccm) | 200 | 100 | 50 | 0 |
| $Cl_2$ (sccm) | 20 | 0 | 0 | 0 |
| $BBr_3$ (sccm) | 0 | 100 | 150 | 200 |
| HBr (sccm) | 0 | 40 | 40 | 40 |
| Pressure (mtorr) | 220 | 240 | 240 | 240 |
| Al. etch rate (A°/min) | 4,540 | 3,720 | 5,510 | 7,190 |
| Pr. etch rate (A°/min) | 3,850 | 1,120 | 1,640 | 1,720 |
| Selectivity | 1.18 | 3.32 | 3.36 | 4.18 |

**FIG. 6**

| PARAMETER | EXPERIMENT NUMBER | | | |
|---|---|---|---|---|
| | 12 | 13 | 14 | 15 |
| $BCl_3$ (sccm) | 0 | 150 | 0 | 150 |
| $Cl_2$ (sccm) | 0 | 100 | 0 | 100 |
| $BBr_3$ (sccm) | 150 | 0 | 150 | 0 |
| $Br_2$ (sccm) | 100* | 0 | 100* | 0 |
| Pressure (mtorr) | 200 | 200 | 200 | 200 |
| Al. etch rate ($A^o$/min) | 12,500 | 15,900 | 10,600 | 13,600 |
| Pr. etch rate ($A^o$/min) | 1,600 | 7,700 | 1,100 | 8,300 |
| Selectivity | 7.81 | 2.06 | 9.64 | 1.64 |

## FIG. 7

| PARAMETER | EXPERIMENT NUMBER | | | |
|---|---|---|---|---|
| | 16 | 17 | 18 | 19 |
| HCl (sccm) | 25 | 25 | 25 | 25 |
| $BCl_3$ (sccm) | 0 | 50 | 100 | 150 |
| HBr (sccm) | 25 | 25 | 25 | 25 |
| $BBr_3$ (sccm) | 150 | 100 | 50 | 0 |
| Pressure (mtorr) | 200 | 200 | 200 | 200 |
| Al. etch rate ($A^o$/min) | 7,460 | 6,220 | 6,120 | 2,540 |
| Pr. etch rate ($A^o$/min) | 1,810 | 1,490 | 1,320 | 877 |
| Selectivity | 4.12 | 4.17 | 4.64 | 2.90 |

## FIG. 8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EXTENDED ABSTRACTS, vol. 86-2, 19th-24th October 1986, page 439, Princeton, NJ, US; H.B. BELL et al.: "Characterization of Al/Si reactive ion etching in BBr3/Cl2 versus BCl3/Cl2 mixtures" * Whole article * --- | 1-4,6,9 ,10 | C 23 F 4/00 H 01 L 21/31 |
| X | JOURNAL OF VACUUM SCIENCE AND TECHNOLOGY: PART A, vol. 3, no. 3, May/June 1985, pages 962-966, American Vacuum Society, Woodbury, New York, US; A.L. KEATON et al.: "Aluminum etching in boron tribromide plasmas" * Page 964, point B: "Aluminum etching" * | 1-4,6,8 | |
| Y | IDEM --- | 5,7,9, 10 | |
| Y | JOURNAL OF VACUUM SCIENCE AND TECHNOLOGY: PART A, vol. 15, no. 2, March/April 1978, pages 334-337, American Vacuum Society, Woodbury, New York, US; P.M. SCHAIBLE et al.: "Reactive ion etching of aluminum and aluminum alloys in an rf plasma containing halogen species" * Page 334; abstract * --- | 5,7,9, 10 | TECHNICAL FIELDS SEARCHED (Int. Cl.4) C 23 F 4/00 H 01 L 21/00 |
| A | PATENT ABSTRACTS OF JAPAN, vol. 4, no. 135 (C-25)[617], 20th September 1980, page 94 C 25; & JP-A-55 85 670 (FUJITSU K.K.) 27-06-1980 --- | | |
| D,A | DE-A-3 037 876 (MITSUBISHI DENKI K.K.) --- -/- | | |

The present search report has been drawn up for all claims

| Place of search | Date of completion of the search | Examiner |
|---|---|---|
| THE HAGUE | 26-09-1988 | TORFS F.M.G. |

EPO FORM 1503 03.82 (P0401)

Application Number

EP 88 10 9250

**European Patent Office**

## EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | GB-A-2 026 395 (WESTERN ELECTRIC CO.) --- | | |
| A | FR-A-2 312 114 (IBM) ----- | | |
| | | | |
| | | | TECHNICAL FIELDS SEARCHED (Int. Cl.4) |

The present search report has been drawn up for all claims

| Place of search | Date of completion of the search | Examiner |
|---|---|---|
| THE HAGUE | 26-09-1988 | TORFS F.M.G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)